# EUROPÄISCHE PATENTSCHRIFT

(11) **EP 3 425 685 B1**
(45) Veröffentlichungstag und Bekanntmachung des Hinweises auf die Patenterteilung: **28.10.2020**
(21) Anmeldenummer: 17179599.0
(22) Anmeldetag: 04.07.2017
(51) Int. Cl.: H01L 33/56, H01L 33/52

(54) **PRIMER**
PRIMERS
PRIMAIRE

(43) Veröffentlichungstag der Anmeldung: 09.01.2019
(73) Patentinhaber: Peters Research GmbH & Co. Kommanditgesellschaft, 47906 Kempen (DE)
(72) Erfinder: KALL, Dirk, 41334 Nettetal (DE); TEKATH, Johannes, 48653 Coesfeld (DE); SUPPA, Dr. Manfred, 44803 Bochum (DE); SCHWARTZ, Ralf, 47906 Kempen (DE)
(74) Vertreter: Dr. Stark & Partner Patentanwälte mbB

(56) Entgegenhaltungen:
- WO-A2-2009/118985
- US-A1- 2009 045 422
- US-A1- 2013 099 212

## Beschreibung

Die Erfindung betrifft Lumineszenskonversions-LED's, die mit einer Konversionsschicht sowie einer hierauf vorzusehenden, farblosen oder farbigen sowie klar transparenten oder eingetrübten Vergussmasse versehen sind.

Aus der Praxis sind derartige LED's bekannt, bei denen durch die Konversionsschicht sowie die Vergussmasse sowohl die beabsichtigte Farbtemperatur als auch die gewünschte IP-Klasse erreicht werden kann. Zudem ist es möglich, über eine insoweit verbesserte Diffusionsbeständigkeit gegenüber bekannten Silikonkapselungen auf dem Chip einen deutlich verbesserten Schutz gegen schwefelhaltige Atmosphärilien zu erreichen, wodurch eine Verlängerung der Lebensdauer der LED's bewirkt werden kann. Zudem kann durch den Verguss ein Berührungsschutz gegen die anliegende elektrische Spannung erzielt werden.

Dokument US 2013/0099212 A1 offenbart eine Lumineszenskonversions-LED mit einer organischen / anorganischen Hybridschicht zwischen einer Konversionsschicht und einer Vergussmasse.

Nachteilig hierbei ist, dass bei derartigen Beschichtungen eine Verschiebung der Farbtemperatur zu höheren Temperaturen hin erfolgen kann, sofern die Schichtdicke eine gewisse Beschichtungsdicke (etwa 200 µm) erreicht. Dies hängt jedoch von dem verwendetem LED-Typ und der entsprechenden Bauform ab und ist insbesondere bei Lumineszenskonversions-LED's gegeben.

Bei solchen Konversions-LED's wird ein blau emittierender Chip mit einer Konversionsschicht überdeckt, welche einen Lumineszensfarbstoff enthält. Das kurzwellige energiereiche blaue Licht regt diesen Lumineszensfarbstoff zum Leuchten an, wodurch dann langwelligeres energieärmeres gelbes Licht abgegeben wird. Da nicht das gesamte blaue Licht umgewandelt wird, ergibt sich aus der resultierenden additiven Farbmischung dann das gewünschte weiße Licht.

Dabei wird üblicherweise ein Teil des nicht konvertierten blauen Lichtes an der Grenzfläche zur Luft hin totalreflektiert und kann somit dann doch in gelberes Licht umgewandelt werden. Je höher dabei der Gelbanteil, desto geringer ist die Farbtemperatur.

Wenn eine Beschichtung oder ein Verguss auf einer solchen LED vorgesehen wird, wird die Totalreflektion an der Grenzfläche zur Luft aufgehoben, da die neue Grenzfläche zwischen Konversionsschicht und Verguss aufgrund des sehr ähnlichen Brechungsindizes der beiden Materialien nicht mehr die Bedingungen für eine Totalreflektion erfüllt. Das blaue Licht wird nun aus der Konversionsschicht austreten, und der Gelbanteil wird entsprechend geringer. Hierdurch verschiebt sich folglich die Farbtemperatur zu einer höheren, kaltweißen Lichtfarbe.

Problematisch ist weiterhin, dass die Benetzung zwischen der meist silikonhaltigen Konversionsschicht und der darauf anzuordnenden Vergussmasse häufig nicht optimal ist, so dass es zu Haftverlusten kommt. Hierdurch kann sich ein kleiner Luftspalt zwischen der Konversionsschicht und der Vergussmasse bilden, so dass es in diesem Bereich dann doch zu einer Totalreflektion der blauen Lichtwellen kommt. Da diese Fehlbenetzung nicht durchgängig ist, können in einer Leuchteinheit mit mehreren LED's dann deutlich verschiedene Farbtemperaturen vorkommen, wodurch keine einheitliche Beleuchtung mit dieser Leuchteinheit möglich ist.

Ein Lösungsansatz besteht darin, Abstandshalter in Form von Häubchen über den LED's vorzusehen, wodurch ein definierter Luftspalt zwischen Konversionsschicht und Vergussmasse geschaffen wird. Allerdings ist diese Lösung aufwendig und auch nicht für viele LED-Typen am Markt verfügbar.

Ein weiterer Lösungsansatz besteht in der Verwendung benetzungsverhindernder Materialien auf der Konversionsschicht. Jedoch können sich diese Materialien negativ auf die Schutzwirkung des Vergusses auswirken, da sie die Haftung, welche Grundvoraussetzung für eine Schutzwirkung ist, zwischen Verguss und Konversationsschicht reduzieren.

Ein alternativer Lösungsansatz besteht in der Verwendung von Streupartikel, wodurch jedoch der klar transparente Charakter des Vergusses verloren geht.

Aufgabe der Erfindung ist es, die vorgenannten Nachteile zu vermeiden und eine Möglichkeit anzugeben, bei Lumineszenskonversions-LED's, welche mit einer Konversionsschicht sowie einer hierauf vorzusehenden, klar transparenten Vergussmasse versehen sind, eine einheitliche warmweiße Lichtfarbe zu erzielen.

Diese Aufgabe wird gelöst durch einen Primer, zum einen zur Haftvermittlung zwischen der Konversionsschicht einer unter anderem blaue Lichtwellen emittierenden Lumineszenskonversions-LED und einer hierauf vorzusehenden, farblosen oder farbigen sowie klar transparenten oder eingetrübten Vergussmasse und zum anderen zur Beugung der die Konversionsschicht durchdringenden blauen Lichtwellen derart, dass zumindest ein Teil der gebeugten blauen Lichtwellen an dem Übergang vom Primer zur Vergussmasse reflektiert werden und durch den Primer zurück in die Konversionsschicht gelangen, wobei der Primer ein nanoskaliges Metalloxid zur Beugung der die Schicht durchdringenden blauen Lichtwellen aufweist und sich aus einer das Metalloxid enthaltenden ersten Komponente und einer einen isocyanatfunktionellen Bestandteil enthaltenden zweiten Komponente zusammensetzt.

Hierdurch wird sichergestellt, dass zwischen der Konversionsschicht und der Vergussmasse eine durchgängig einheitliche Haftung gegeben ist, so dass keine deutlich verschiedenen Farbtemperaturen mehr resultieren können.

Erfindungsgemäß kann der isocyanatfunktionelle Bestandteil ein prepolymeres Toluol-2,4-Diisocyanat umfassen, vorteilhafterweise ausschließlich aus diesem gebildet sein.

Vorzugsweise kann die erste Komponente wenigstens 14 % des Metalloxids und wenigstens 50 % eines Lösemittels oder mehrerer Lösemittel, vorteilhafterweise wenigstens 50 % eines Lösemittels aus der Reihe der Alkohole sowie wenigstens 30 % eines Lösemittels aus der Reihe der Acetate, umfassen.

Dabei kann bei der ersten Komponente entweder das oder die Lösemittel aus der Reihe der der Acetate sein oder aber das Lösemittel aus der Reihe der Alkohole Methoxyproylacetat sein und/oder das Lösemittel aus der Reihe der Acetate Butylacetat sein.

Vorteilhafterweise kann die zweite Komponente wenigsten 20 % des Isocyanats und wenigstens 70 % eines Lösemittels umfassen.

Dabei kann bei der zweiten Komponente das Lösemittel Butylacetat und/oder Dipropylenglykolmethlyester sein.

Bei einem bevorzugten Ausführungsbeispiel der Erfindung kann das Mischungsverhältnis erste Komponente zu zweiter Komponente in etwa 2:1 betragen.

Die Erfindung betrifft weiterhin eine Lumineszenskonversions-LED mit einer Konversionsschicht und einer hierauf vorzusehenden, klar transparenten Vergussmasse.

Zur Lösung der eingangs geschilderten Probleme ist hierbei zwischen der Konversionsschicht und der Vergussmasse ein erfindungsgemäßer Primer, zum einen zur Haftvermittlung zwischen der Konversionsschicht und der Vergussmasse und zum anderen zur Teilreflektion von blauen Lichtwellen zurück in die Konversionsschicht, vorgesehen.

Dabei kann die Vergussmasse als Beschichtung zum Schutz der Elektronik gegenüber Umwelteinflüssen ausgebildet sein.

Erfindungsgemäß kann die Vergussmasse farblos oder farbig sowie klar transparent oder eingetrübt ausgebildet sein.

Vorteilhafterweise kann eine zusätzlich vorgesehene weitere Beschichtung ein Silikonpolymer oder ein Polyurethanpolymer enthalten.

Die Erfindung betrifft weiterhin ein Verfahren zur Beschichtung der Konversionsschicht einer erfindungsgemäßen Lumineszenskonversions-LED. Zur Lösung der eingangs geschilderten Probleme wird die Konversionsschicht vor dem Vorsehen einer klar transparenten Vergussmasse mit einem erfindungsgemäßen Primer, zum einen zur Haftvermittlung zwischen der Konversionsschicht und der Vergussmasse und zum anderen zur Teilreflektion von blauen Lichtwellen zurück in die Konversionsschicht, beschichtet.

Vorzugsweise kann die Beschichtung zur positionsgenauen und mengengenauen Aufbringung mittels eines Ink-Jet-Verfahrens appliziert werden.

## Patentansprüche

1. Primer zum einen zur Haftvermittlung zwischen der Konversionsschicht einer unter anderem blaue Lichtwellen emittierenden Lumineszenskonversions-LED und einer hierauf vorzusehenden, farblosen oder farbigen sowie klar transparenten oder eingetrübten Vergussmasse und zum anderen zur Beugung der die Konversionsschicht durchdringenden blauen Lichtwellen derart, dass zumindest ein Teil der gebeugten blauen Lichtwellen an dem Übergang vom Primer zur Vergussmasse reflektiert werden und durch den Primer zurück in die Konversionsschicht gelangen, wobei der Primer ein nanoskaliges Metalloxid zur Beugung der die Schicht durchdringenden blauen Lichtwellen aufweist und sich aus einer das Metalloxid enthaltenden ersten Komponente und einer einen isocyanatfunktionellen Bestandteil, vorzugsweise Isocyanat, enthaltenden zweiten Komponente zusammensetzt.

2. Primer nach dem vorhergehenden Anspruch, wobei der isocyanatfunktionelle Bestandteil ein prepolymeres Toluol-2,4-Diisocyanat umfasst, vorteilhafterweise ausschließlich aus diesem gebildet ist.

3. Primer nach einem der vorhergehenden Ansprüche, wobei die erste Komponente wenigstens 14 % des Metalloxids und wenigstens 50 % eines Lösemittels oder mehrerer Lösemittel, vorteilhafterweise wenigstens 50 % eines Lösemittels aus der Reihe der Alkohole sowie wenigstens 30 % eines Lösemittels aus der Reihe der Acetate, umfasst.

4. Primer nach dem vorhergehenden Anspruch, wobei bei der ersten Komponente entweder das oder die Lösemittel aus der Reihe der Acetate ist bzw. sind oder aber das Lösemittel aus der Reihe der Alkohole Methoxypropylacetat ist und/oder das Lösemittel aus der Reihe der Acetate Butylacetat ist.

5. Primer nach einem der vorhergehenden Ansprüche, wobei die zweite Komponente wenigsten 20 % des isocyanatfunktionellen Bestandteil und wenigstens 70 % eines Lösemittels umfasst.

6. Primer nach dem vorhergehenden Anspruch, wobei bei der zweiten Komponente das Lösemittel Butylacetat und/oder Dipropylenglykolmethlyester ist.

7. Primer nach einem der vorhergehenden Ansprüche, wobei das Mischungsverhältnis erste Komponente zu zweiter Komponente in etwa 2:1 beträgt.

8. Lumineszenskonversions-LED mit einer Konversionsschicht und einer hierauf vorzusehenden, klar transparenten Vergussmasse, wobei zwischen der Konversionsschicht und der Vergussmasse ein Primer nach den vorhergehenden Ansprüchen, zum einen zur Haftvermittlung zwischen der Konversionsschicht und der Vergussmasse und zum anderen zur Teilreflektion von blauen Lichtwellen zurück in die Konversionsschicht, vorgesehen ist.

9. Lumineszenskonversions-LED nach dem vorhergehenden Anspruch, wobei die Vergussmasse als Beschichtung zum Schutz der Elektronik gegenüber Umwelteinflüssen ausgebildet ist.

10. Lumineszenskonversions-LED nach dem vorhergehenden Anspruch, wobei die Vergussmasse farblos oder farbig sowie klar transparent oder eingetrübt ausgebildet ist.

11. Lumineszenskonversions-LED nach einem der Ansprüche 9 oder 10, wobei die zusätzlich vorgesehene weitere Beschichtung ein Silikonpolymer oder ein Polyurethanpolymer enthält.

12. Verfahren zur Beschichtung der Konversionsschicht einer Lumineszenskonversions-LED nach einem der Ansprüche 8 bis 11, wobei die Konversionsschicht vor dem Vorsehen einer klar transparenten Vergussmasse mit einem Primer nach einem der Ansprüche 1 bis 7, zum einen zur Haftvermittlung zwischen der Konversionsschicht und der Vergussmasse und zum anderen zur Teilreflektion von blauen Lichtwellen zurück in die Konversionsschicht, beschichtet wird.

13. Verfahren nach dem vorhergehenden Anspruch, wobei die Beschichtung zur positionsgenauen und mengengenauen Aufbringung mittels eines Ink-Jet-Verfahrens appliziert wird.

## Claims

1. Primer, for providing adherence between the conversion layer of a luminescence conversion LED, emitting, among others, blue light waves, and an embedding compound, colourless or coloured, and clear transparent or turbid, provided thereon, and for diffracting the blue light waves penetrating through the conversion layer, in such a way that at least a part of the diffracted blue light waves are reflected at the transition from the primer to the embedding compound, and pass through the primer back into the conversion layer, wherein the primer comprises a nano-scale metal oxide for the diffraction of the blue light waves penetrating through the layer, and is itself composed of a first component containing the metal oxide and a second component containing an isocyanate-functional constituent part, preferably isocyanate.

2. Primer according to the preceding claim, wherein the isocyanate-functional constituent part comprises a prepolymer toluol-2,4-diisocyanate, and advantageously is formed from this exclusively.

3. Primer according to any one of the preceding claims, wherein the first component comprises at least 14% of the metal oxide and at least 50% of a solvent or several solvents, advantageously at least 50% of a solvent from the series of the alcohols, as well as at least 30% of a solvent from the series of the acetates.

4. Primer according to any one of the preceding claims, wherein, with regard to the first component, either the solvent or solvents is or are from the series of the acetates, or the solvent is from the series of the alcohols is methopropyl acetate, and/or the solvent from the series of the acetates is butylacetate.

5. Primer according to any one of the preceding claims, wherein the second component comprises at least 20% of the isocyanate-functioning constituent part and at least 70% of a solvent.

6. Primer according to the preceding claim, wherein, with regard to the second component, the solvent is butyl acetate and/or dipropylene glycol methyl ester.

7. Primer according to any one of the preceding claims, wherein the mixing ratio of the first component to the second component is approximately 2:1.

8. Luminescence conversion LED, with a conversion layer and a clear transparent embedding compound to be provided thereon, wherein a primer according to any one of the preceding claims is provided between the conversion layer and the embedding compound for providing adherence between the conversion layer and the embedding compound and for the partial reflection of blue light waves back into the conversion layer.

9. Luminescence conversion LED according to the preceding claim, wherein the embedding compound is configured as a coating for the protection of the electronics against environmental influences.

10. Luminescence conversion LED according to the preceding claim, wherein the embedding compound is configured as colourless or coloured, as well as clear transparent or turbid.

11. Luminescence conversion LED according to any one of the preceding claims 9 or 10, wherein the additional further coating provided contains a silicone polymer or a polyurethane polymer.

12. Method for the coating of the conversion layer of a luminescence conversion LED according to any one of the preceding claims 8 to 11, wherein the conversion layer, before the provision of a clear transparent embedding compound, is coated with a primer according to any one of claims 1 to 7 for providing adherence between the conversion layer and the embedding compound and for the part reflection of blue light waves back into the conversion layer.

13. Method according to any one of the preceding claims, wherein, for precise position and precise quantity application, the coating is applied by means of an ink-jet process.

## Revendications

1. Primaire conçu, d'une part, pour procurer une adhérence entre la couche de conversion d'une DEL de conversion de luminescence émettant, entre autres, des ondes de lumière bleue, et une masse de scellement incolore ou colorée, ainsi que transparente ou opacifiée, devant être prévue sur ladite couche ; et d'autre part, pour diffracter les ondes de lumière bleue traversant ladite couche de conversion, de façon telle qu'au moins une partie desdites ondes de lumière bleue diffractées soit réfléchie à la transition entre ledit primaire et ladite masse de scellement, puis retourne dans ladite couche de conversion en traversant ledit primaire, lequel primaire comporte un oxyde métallique nanométrique affecté à la diffraction des ondes de lumière bleue qui traversent ladite couche, et consiste en un premier composant renfermant ledit oxyde métallique, et en un second composant renfermant une part constitutive à fonction isocyanate, de préférence un isocyanate.

2. Primaire selon la revendication précédente, dans lequel la part constitutive à fonction isocyanate inclut un 2,4-diisocyanate de toluène prépolymère et est, de manière avantageuse, constituée exclusivement de ce dernier.

3. Primaire selon l'une des revendications précédentes, dans lequel le premier composant inclut au moins 14 % de l'oxyde métallique et au moins 50 % d'un solvant ou de plusieurs solvants, avantageusement au moins 50 % d'un solvant de la série des alcools, ainsi qu'au moins 30 % d'un solvant de la série des acétates.

4. Primaire selon la revendication précédente, dans lequel, dans le premier composant, le ou les solvant(s) est (sont) de la série des acétates, ou bien le solvant de la série des alcools est de l'acétate de méthoxypropyle, et le solvant de la série des acétates est de l'acétate de butyle.

5. Primaire selon l'une des revendications précédentes, dans lequel le second composant inclut au moins 20 % de la part constitutive à fonction isocyanate et au moins 70 % d'un solvant.

6. Primaire selon la revendication précédente, dans lequel, dans le second composant, le solvant est de l'acétate de butyle et/ou de l'éther méthylique de dipropylène glycol.

7. Primaire selon l'une des revendications précédentes, dans lequel le rapport de mélange, du premier composant au second composant, est d'environ 2:1.

8. DEL de conversion de luminescence, comprenant une couche de conversion et une masse transparente de scellement devant être prévue sur ladite couche, dans lequel un primaire conforme aux revendications précédentes est prévu, entre la couche de conversion et la masse de scellement, d'une part pour procurer une adhérence entre ladite couche de conversion et ladite masse de scellement et, d'autre part, pour instaurer la rétroréflexion partielle d'ondes de lumière bleue dans ladite couche de conversion.

9. DEL de conversion de luminescence selon la revendication précédente, dans lequel la masse de scellement est conçue en tant que revêtement affecté à la protection de l'électronique vis-à-vis d'influences de l'espace environnant.

10. DEL de conversion de luminescence selon la revendication précédente, dans lequel la masse de scellement est de réalisation incolore ou colorée, ainsi que transparente ou opacifiée.

11. DEL de conversion de luminescence selon l'une des revendications 9 ou 10, dans lequel l'autre revêtement, additionnellement prévu, renferme un polymère de silicone ou un polymère de polyuréthane.

12. Procédé dévolu au revêtement de la couche de conversion d'une DEL de conversion de luminescence conforme à l'une des revendications 8 à 11, dans lequel la couche de conversion est revêtue d'un primaire conforme à l'une des revendications 1 à 7, avant qu'une masse de scellement transparente ne soit prévue, d'une part pour procurer une adhérence entre ladite couche de conversion et ladite masse de scellement et, d'autre part, pour instaurer la rétroréflexion partielle d'ondes de lumière bleue dans ladite couche de conversion.

13. Procédé selon la revendication précédente, dans lequel le revêtement est appliqué au moyen d'un procédé à jets d'encre, en vue du dépôt avec positionnement précis et quantité précise.
